(19) Europäisches Patentamt

European Patent Office

Office européen des brevets

(11) Publication number: **0 212 585 B1**

# EUROPEAN PATENT SPECIFICATION

(45) Date of publication of patent specification: **18.12.91** (51) Int. Cl.⁵: **H01L 21/31**, H01L 21/306

(21) Application number: **86111282.9**

(22) Date of filing: **14.08.86**

(54) Selective and anisotropic dry etching.

(30) Priority: **27.08.85 US 769647**
**27.08.85 US 769832**

(43) Date of publication of application:
**04.03.87 Bulletin 87/10**

(45) Publication of the grant of the patent:
**18.12.91 Bulletin 91/51**

(84) Designated Contracting States:
**DE FR GB**

(56) References cited:
**DE-A- 3 118 839**
**FR-A- 2 230 148**

**JOURNAL OF VACUUM SCIENCE & TECHNOLOGY: PART B, vol. 3, no. 1, second series, January-February 1985, pages 16-19, American Vacuum Society, new York, US; M. KIMIZUKA et al.: "Pattern profile control of polysilicon plasma etching"**

(73) Proprietor: **International Business Machines Corporation**
**Old Orchard Road**
**Armonk, N.Y. 10504(US)**

(72) Inventor: **Carbaugh, Susanna, Rachel**
**9310 Mathis Avenue**
**Manassas Va. 22 110(US)**
Inventor: **Stanasolovich, David**
**8464 McKenzie Circle**
**Manassas Va. 22 110(US)**
Inventor: **Polavarapu, Marty S.**
**10 037 Elderberry Court**
**Manassas Va. 22 110(US)**
Inventor: **Ng, Hung Yip**
**8657 Bruton Parish Court, Apt. 104**
**Manassas Va. 22 110(US)**

(74) Representative: **Kreidler, Eva-Maria, Dr. rer. nat.**
**Schönaicher Strasse 220**
**W-7030 Böblingen(DE)**

## Description

This invention relates to compositions and a method for reactive ion etching.

The manufacturing of semiconductor devices usually involves the patterned etching of specific layers comprising the device. This etching can be done in a variety of ways. Formerly, such etching was done with wet chemicals. These processes have a number of disadvantages. The etching is isotropic, that is, etching occurs laterally as well as vertically resulting in an etched linewidth which is larger than the resist image. Furthermore, the chemicals used are typically very hazardous to personnel and undesirably polluting. Finally, the etching step must be followed by a rinse and dry step. The additional steps increase processing time and decrease yield.

More recent processes employ gas plasmas. Because the gases are contained within a sealed reaction chamber there is no hazard to personnel. Much smaller quantities of etchant are used and the gaseous nature of the effluent allows for "scrubbing" to remove pollutants. Not only are the rinse and dry steps removed, but resist removal can be performed in the chamber after completion of the etching. Processing time is decreased and yield is increased.

If the use of a gas plasma to etch is combined with the technique of accelerating the etchant species toward the article being etched, the technique is known as Reactive Ion Etching (RIE). In addition to the advantages gained by use of a gas plasma, etching performed in this way can be anisotropic, that is predominantly vertical. The degree of anisotropy is largely determined by the pressure. The lower the pressure the more anisotropic the etching. This is because at low pressures particles in the chamber have a long mean free path. As particles are accelerated toward the surface being etched they are less likely to collide with other particles. Collisions with other particles change the direction of the particle with the result that vertical surfaces are more likely to be attacked at high pressures than at low pressures.

However, selectivity is another factor which must be considered. A perfectly selective process would be one in which the overlying layer would etch and the underlying layer would not. In real life this is never achieved. Selectivity is expressed as a ratio of the etch rate of the overlying layer to the etch rate of the underlying layer. In general, the lower the pressure the less selective the etching. This is because the particles have high kinetic energy with the result that non-selective physical etching by particle bombardment occurs along with selective chemical etching.

DE-A-31 18 839 discloses a method to manufacture a device whereby silicon is etched in a plasma by etch gases such as $CF_4$ in admixture with $O_2$ or inert gas, or fluorocarbons such as $CCl_2F_2$, $CHF_3$ or $CBrF_3$.

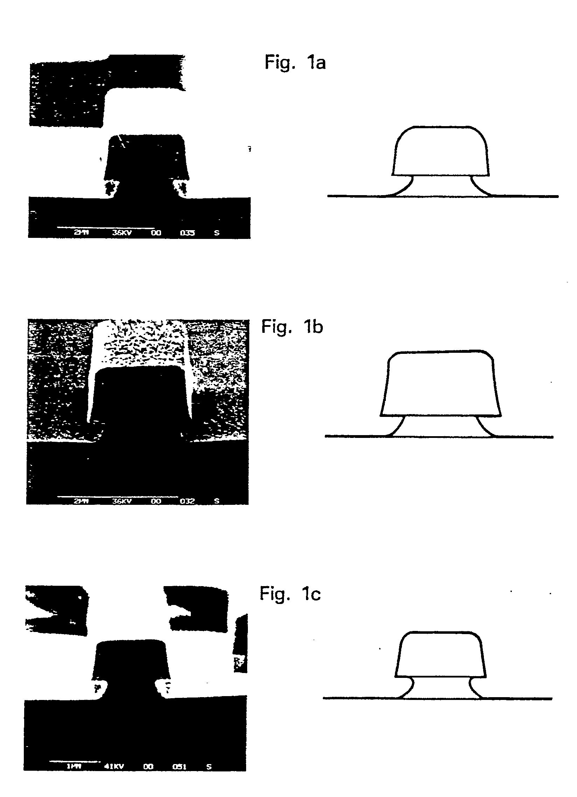

In J. Vac. Sci. Technol. B3(1), Jan/Feb 1985, pp. 16 to 19, M. Kimizuka et al. "Pattern profile control of polysilicon plasma etching" a reactive gas for polysilicon etching is disclosed which consists of (a) pure $CCl_2F_2$ of (b) $CCl_2F_2$ - 50 % $H_2$ - (Fig. 1).

FR-A-2 230 148 discloses a method for plasma etching silicon/silicide, silicon/ silicon nitride using gas mixtures of $CF_4$/hydrogen or $CF_4$/ammonia. According to the description $CF_2Cl_2$/hydrogen or $CF_3Cl$/hydrogen may be used in lieu of $CF_4$/hydrogen.

One area of semiconductor manufacturing in which dry etching has been used is in patterning a layer of polysilicon or refractory metal silicide which overlies an insulating layer such as silicon dioxide, silicon nitride, or silicon oxynitride. A specific example is the definition of polysilicon or polycide gate electrodes in the manufacturing of (MOSFET) devices. Many etch formulations have been proposed which vary in their selectivity and anisotropy. Gases which have been tried are $CClF_3$ and $CCl_2F_2$.

Although $CClF_3$ has been used at relatively high pressures (less than 133 $\mu$bar) to etch polysilicon over silicon dioxide with excellent selectivity, the etching has not been anisotropic. Fig. 1 shows the etched profiles of N+ polysilicon etched at various pressures in pure $CClF_3$. Excessive undercutting can be seen at 133 $\mu$bar, as well as at much lower pressures. In pure $CClF_3$ at higher pressures there is thought to be an excess of Cl species over unsaturate species, $CFx^+$. These chlorine species are low energy because of the high pressure and reduced mean free path. They diffuse in random directions and attack both vertical and horizontal surfaces of the layer being etched. Therefore, this process produces substantial undercutting and has a poor directionality.

A low pressure (33.25 $\mu$bar) RIE process has been developed for etching $SiO_2$ with respect to silicon. This involves the addition of molecular hydrogen to $CClF_3$. The addition of molecular hydrogen serves to getter the excess chlorine. This enhances the relative quantity of $CFx^+$ in the ambient. At low pressures, $CFx^+$ etches $SiO_2$ and because there is so little chlorine in the ambient, silicon does not etch.

A process employing $CCl_2F_2$ and argon has been used to etch polysilicon overlying $SiO_2$ at moderate pressure. The selectivity of the process is low (7:1) and it is not anisotropic.

A two-step process has been disclosed for etching layers of molybdenum silicide and poly-

silicon overlying $SiO_2$. Two different etch formulations are required for the two steps. The second etchant which is used to etch the polysilicon comprises $CCl_2F_2$ and $C_2F_6$.

Pure $CCl_2F_2$ has also been used to etch polysilicon overlying $SiO_2$. However, the selectivity of the process is very low, especially at low power density where it approaches 2:1.

It is an object of this invention to provide an improved process for the dry etching of silicon or silicides.

It is a further object of this invention to provide a process for the dry etching of polysilicon or silicides which is both anisotropic and selective to an underlying layer of an oxide or nitride or an oxynitride of silicon.

It is another object of this invention to provide an anisotropic selective process for the dry etching of polysilicon or silicides which can be carried out at moderate to high pressures and low power density.

In accordance with the invention, mixtures of $CClF_3$ and ammonia or of $CCl_2F_2$ and ammonia are employed at moderate pressures in a reactive ion etching chamber to anisotropically etch polysilicon or silicides with excellent selectivity to an underlying layer of an oxide or nitride of silicon.

| | |
|---|---|
| Figs. 1a, | 1b and 1c are a series of SEMs showing the etched profiles of N+ polysilicon etched in pure $CClF_3$ at various pressures. |
| Fig. 1a | shows the profile obtained at 29.3 μbar. |
| Fig. 1b | shows the profile obtained at 79.8 μbar. |
| Fig. 1c | shows the profile obtained at 133 μbar. |
| Fig. 2 | is a schematic cross-sectional view of apparatus which can be used to carry out the process of the present invention. |
| Fig. 3 | is a schematic enlarged cross-sectional view of a substrate on which the process of this invention has been practiced. |
| Figs. 4a, | 4b, 4c and 4d are a series of SEMs showing the effect of the %$NH_3$ in $CClF_3$ on the etched profiles of N+ polysilicon at 133 μbar. |
| Fig. 4a | shows the effect of pure $CClF_3$. |
| Fig. 4b | shows the effect of 20% $NH_3$ in $CClF_3$ (v/v). |
| Fig. 4c | shows the effect of 30% $NH_3$ in $CClF_3$ (v/v). |
| Fig. 4d | shows the effect of 50% $NH_3$ in $CClF_3$ (v/v). |
| Figs. 5a, | 5b and 5c are a series of SEMs showing the effect of the %$NH_3$ in $CClF_3$ on the etched profiles of N+ polysilicon at 79.8 μbar. |
| Fig. 5a | shows the effect of pure $CClF_3$. |
| Fig. 5b | shows the effect of 20% $NH_3$ in $CClF_3$ (v/v). |
| Fig. 5c | shows the effect of 50% $NH_3$ in $CClF_3$ (v/v). |
| Figs. 6a, | 6b and 6c are SEMs showing the effect of the %$NH_3$ in $CCl_2F_2$ on the etched profiles on N+ polysilicon at 93.1 μbar. |
| Fig. 6a | shows pure $CCl_2F_2$. |
| Fig. 6b | shows 33.3% $NH_3$ by volume in $CCl_2F_2$. |
| Fig. 6c | shows 37.5% $NH_3$ by volume in $CCl_2F_2$. |

1. Terminology

Silicon layers: this refers to layers consisting of silicon. These layers may be single crystal or polycrystalline. They may be doped to either conductivity type at any level. Silicon may also be contained as part of an intermetallic compound such as a silicide of a refractory metal such as molybdenum, tungsten, titanium or tantalum.

Silicon-containing compounds: this refers to chemical compounds containing silicon covalently bonded to other elements, such as nitrogen or oxygen. Such compounds include silicon oxide, silicon dioxide, silicon nitride, and silicon oxynitride.

Plasma etching: etching which proceeds by means of a plasma generated by an RF discharge. The predominant removal mechanism is chemical reaction.

Ion Beam Etching: etching which proceeds by means of accelerated species bombarding the surface to be etched. The predominant removal mechanism is physical momentum transfer. Also called ion milling or sputter etching.

Reactive Ion Etching: etching which proceeds by means of a plasma in which the reactant species are accelerated toward the surface to be etched. The removal mechanism is a combination of chemical and physical interactions between the accelerated species and the surface.

Etch Profile: wall configuration produced in an etched structure, which may be:
Vertical--straight walls on a plane with the resist edge and perpendicular to the surface of the substrate.
Undercut--sloped walls in which some portion of the wall lies under the resist.

Isotropic: etching which proceeds at a uniform rate in all directions (both vertically and laterally). It results in undercutting in which the etched region closest to the resist undercuts to a dimension approximately equal to that of the vertical etch dimension.

Anisotropic: etching which is directional; that is, which proceeds faster in the vertical direction than in the lateral direction. Ideal anisotropic etching produces a vertical etch profile.

Selectivity: the preferential etching of one substance over another which is a result of differences in the rate of chemical reaction between the etchant and each of the substances. It is expressed as the ratio of the etch rates of two adjacent layers (ERR).

## 2. Apparatus

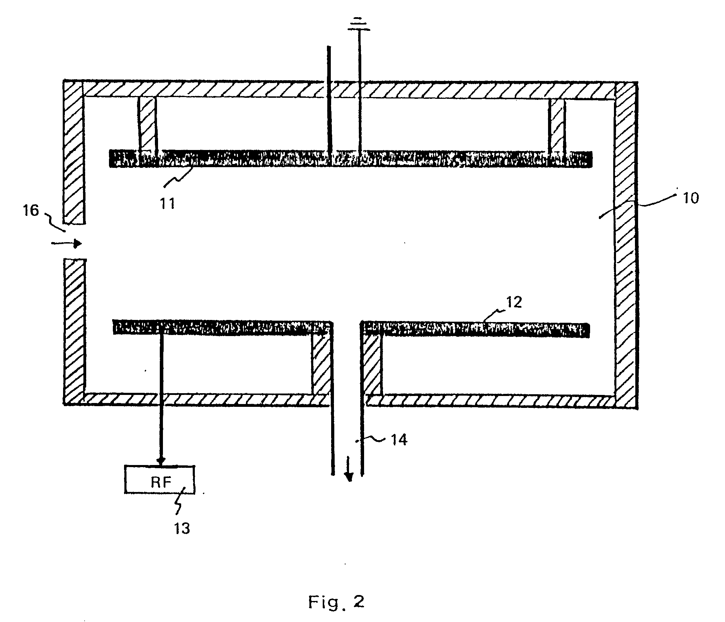

A typical reactive ion etching system is shown in Fig. 2. It comprises etching chamber 10 containing parallel plate electrodes 11 and 12. In this configuration, upper electrode 11 is grounded. Lower electrode 12 is powered by RF generator 13. Either or both electrodes may be water cooled and the distance between them may be adjustable. In a plasma etching system (not shown), the system configuration is similar, but the lower electrode is grounded and the upper electrode is powered.

Etching chamber 10 is evacuated via exhaust pipe 14 by pumping means (not shown). Etchant gas is supplied to etching chamber 10 through gas inlet 16. The system may have multiple gas channels. The flow of the reactive gases can be controlled by pressure and/or flow-rate servo systems.

By introducing a suitable gas or gas mixture into chamber 10 and establishing an electrical field between upper electrode 11 and lower electrode 12, a reactive plasma is generated. The plasma is characterized by a uniform dark space in the immediate vicinity of cathode 12. Volatile products formed during the etching process are exhausted from chamber 10 via exhaust pipe 14.

## 3. Etchant

The etchant gas mixture employed according to the present invention comprises:

    a. a gaseous fluorocarbon capable of supplying CFx and chlorine ions, and

    b. a gas capable of supplying hydrogen ions.

Preferred gaseous fluorocarbons are $CClF_3$ and $CCl_2F_2$, and the preferred source of hydrogen ions is ammonia. The ammonia is employed in an amount effective to increase the selectivity, e.g. in a $CClF_3$: $NH_3$ ratio or in a $CCl_2F_2$: $NH_3$ ratio (v/v) of about 80:20 to about 35:65.

It is theorized that at 133 $\mu$bar with a pure gaseous fluorocarbon there is an excess of chlorine ions over unsaturate species, CFx. As noted above, this excess chlorine diffuses in random directions and attacks both vertical and horizontal surfaces producing substantial undercutting. The addition of hydrogen ions to the fluorocarbon removes the excess of chlorine ions and balances the concentration of CFx ions relative to chlorine ions. Ammonia is preferred over hydrogen gas as the source of hydrogen ions for two reasons. First, ammonia gas provides a much broader process window than hydrogen gas. This is important because if too much hydrogen is added, too much chlorine will be removed and unsaturate species, CFx, will predominate. The result of removing too much chlorine will depend on the pressure. At relatively high pressures, the unsaturate species, CFx, have low energy and coat out as a polymer on all exposed surfaces. The net result is a coating process instead of an etching process. At relatively low pressures, the unsaturate species, CFx, have high energy. As noted above, the addition of hydrogen to $CClF_3$ for example at low pressure (33.25 $\mu$bar) actually produces a process which can be viewed as the opposite of the present invention, i.e. the process will preferentially etch $SiO_2$ over Si, whereas the process of the present invention will preferentially etch Si over $SiO_2$. The $CClF_3/H_2$/low pressure process etches $SiO_2$ because of the predominance of high energy CFx species which are $SiO_2$ etchants. The second reason that ammonia is preferred over hydrogen gas as the source of hydrogen ions is because ammonia produces active nitrogen which is a polymer inhibitor. This gives the added benefit of a reduction in polymer formation. Of course, some polymer will still form on exposed surfaces. That which forms on horizontal surfaces will be removed by the chlorine species in a properly balanced mixture. That which forms on the sidewalls will not be attacked by the accelerated chlorine species and will further reduce the lateral etching which results in undercutting.

It is sometimes desirable to employ an etchant gas mixture containing an inert gas. In this case, the ratio of the fluorocarbon to ammonia is kept the same as the composition without inerts. Inerts increase etch uniformity and help to cool the chamber. Examples of inerts which may be used are the noble gases, especially helium.

## 4. Substrate

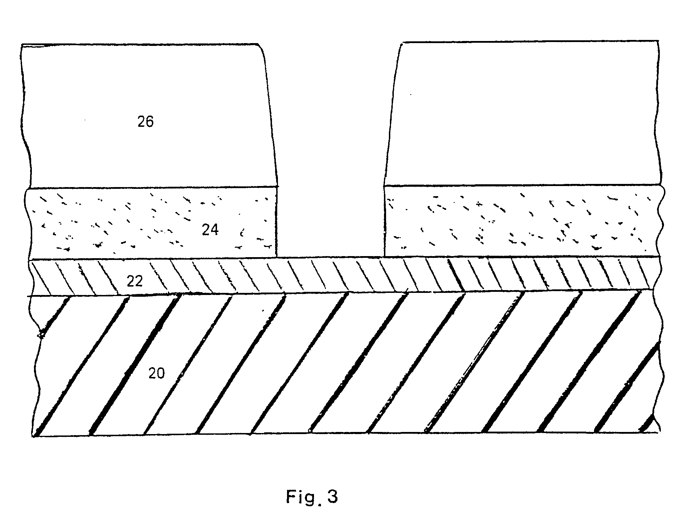

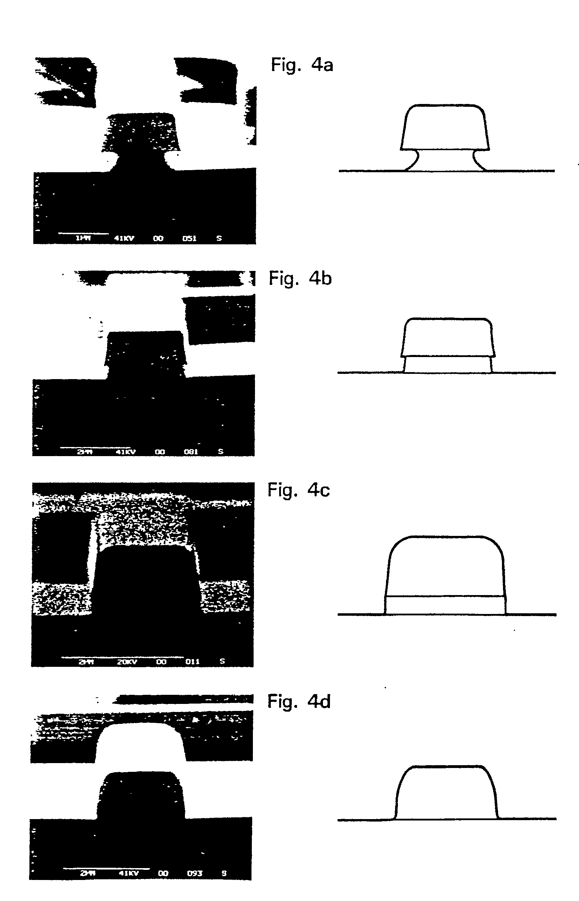

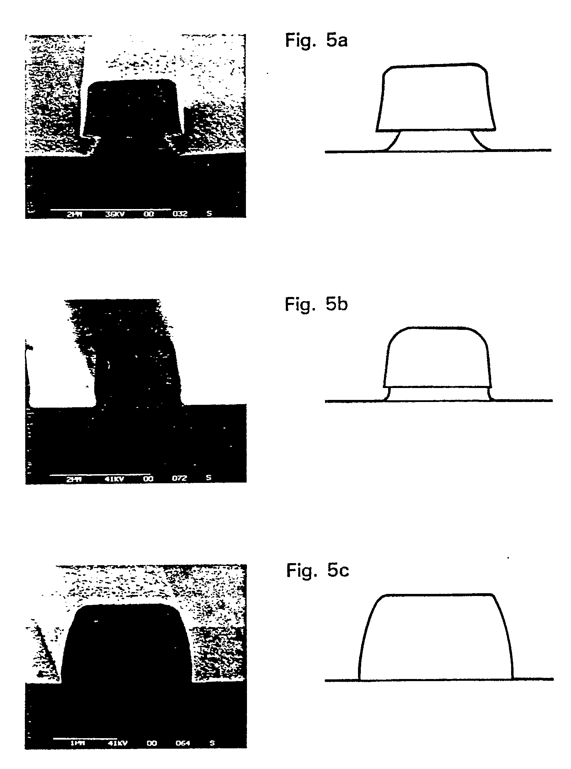

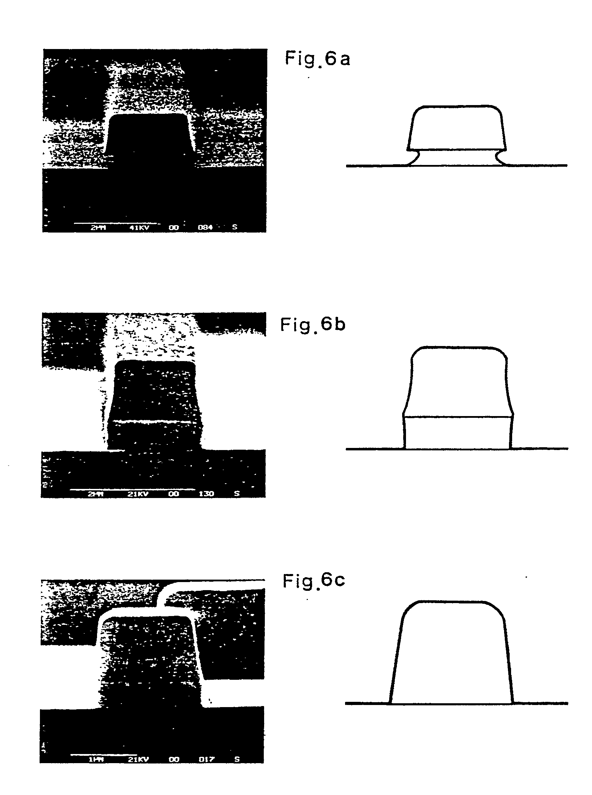

The process of the present invention is used to etch articles with comprise a substrate (20) with one or more layers thereon. (See Fig. 3.) The method permits the preferential etching of an elemental silicon-containing layer (24) of doped polysilicon or a refractory metal silicide over a covalent silicon-containing layer (22) such as SiO, $SiO_2$, silicon nitride, or silicon oxynitride. When the process is used in the preparation of patterned articles, a mask (26) of, for instance, a photoresist or electron beam resist material is applied on top of the upper layer.

## 5. Process

The process of the present invention is carried out under vacuum at pressures between about 79.8 and 133 $\mu$bar. Pressures higher than 133 $\mu$bar ordinarily are not employed because they cause an excessive amount of polymer to coat out on the surfaces, as will be discussed hereinafter. Pressures lower than about 79.8 $\mu$bar result in a reduction in selectivity.

The total flow rate of the gases is generally 15 to 100, preferably about 30 to 60 standard cm$^3$/min (sccm) (standard conditions of 25°C and 1.011 bar)

The RF power supply was operated at a power density between about 0.125 and 0.3 or 0.2 and 0.3 watts/cm$^2$. However, these parameters will be dependent on the apparatus employed.

## 6. Working Examples

General conditions: a parallel plate, radial flow reactor was used. The space between the anode and the cathode was about 9-10 cm. All parts within the etch chamber are constructed of aluminum. RF power at 13.56 MH$^2$ is capacitatively coupled to the bottom electrode while the top electrode and chamber wall are well grounded. The power density is 0.22 W/cm$^2$. The etch gases are introduced through a manifold arrangement at the front of the chamber and evacuated at the back. Etch rates are measured from a laser interferometer trace or by measuring film thickness before and after etch on an IBM 3820 Film Thickness Analyzer. Selectivities are calculated from the measured etch rates.

The substrates are single crystal silicon wafers with <100> orientation. To obtain the MOS structure, 25 nm of gate thermal oxide was grown. Then polysilicon was deposited using LPCVD at 625°C. The polysilicon was subsequently doped with POCl$_3$. The substrates in examples 1, 2 and 3 had 430 nm of polysilicon. The substrates in examples 4 and 5 had 170 nm of polysilicon on which 250 nm of tungsten silicide was deposited using co-evaporation.

## 7. Examples (CClF$_3$ as well as CCl$_2$F$_2$ and ammonia)

### EXAMPLE 1

Pressure -- 79.8 $\mu$bar
Flow rate -- 40 sccm
%NH3 -- 20%

An etch rate of 49 nm/minute was realized in N+ polysilicon. The etch profile was vertical and the ERR of polysilicon to SiO$_2$ was 11:1.

### EXAMPLE 2

Pressure -- 106.4 $\mu$bar
Flow rate -- 40 sccm
%NH3 -- 35%

An etch rate of 54 nm/minute was realized in N+ polysilicon. The etch profile was vertical and the ERR of polysilicon to SiO$_2$ was 18:1.

### EXAMPLE 3

Pressure -- 133 $\mu$bar
Flow rate -- 40 sccm
%NH3 -- 45%

An etch rate of 62 nm/minute was realized in N+ polysilicon. The etch profile was vertical and the ERR of polysilicon to SiO$_2$ was 31:1.

### EXAMPLE 4

Pressure -- 106.4 $\mu$bar
Flow rate -- 40 sccm
%NH3 -- 35%

An etch rate of 54 nm/minute was realized in tungsten silicide. The etch profile was vertical and the ERR of silicide to SiO$_2$ was 18:1.

### EXAMPLE 5

Pressure -- 133 $\mu$bar
Flow rate -- 40 sccm
%NH3 -- 45%

An etch rate of 62 nm/minute was realized in tungsten silicide. The etch profile was vertical and the ERR of silicide to SiO$_2$ was 31:1.

While the invention has been described in conjunction with a reactive ion etching apparatus, it will be understood that a variety of reactors may be employed satisfactorily. Different etching modes, including chemically based concepts like plasma etching and physically based concepts like reactive ion beam etching should be possible with the plasma environments disclosed. It is to be understood that the above-described arrangements and procedures are only illustrative of the principles of the present invention.

## Claims

1. Anisotropic gas plasma process carried out in a reactive ion etching mode using an etchant gas for selectively pattern etching a layer (24) comprising silicon, polysilicon, or a refractory metal silicide overlying a layer (22) comprising an oxide or nitride or oxynitride of silicon, wherein the etchant comprises $CClF_3$ or $CCl_2F_2$ capable of supplying CFx and chlorine ions in admixture with 20 to 65 % by volume of ammonia at a pressure of 79.8 to 133 $\mu$bar.

2. Process of claim 1 wherein the mass flow rate is in the range of 15 to 100 standard $cm^3$/min (sccm), and preferably in the range of 30 to 60 standard $cm^3$/min (sccm).

3. Process of claim 1 wherein said layers (22, 24) form a surface of a semiconductor device.

4. Process of claim 1 wherein the overlying layer (24) is N + polysilicon or tungsten silicide.

5. Process of claim 1 wherein the power density is in the range of 0.125 to 0.3 $W/cm^2$.

6. Etching composition for reactive ion etching comprising $CClF_3$ or $CCl_2F_2$ capable of supplying CFx and chlorine in admixture with 20 to 65 % by volume of ammonia effective to increase the ratio of the etch rate of an overlying layer (24) comprising silicon, polysilicon, or a refractory metal silicide relative to an underlying layer (22) comprising an oxide or nitride or cxynitride of silicon.

7. Composition of claim 6 additionally comprising an inert gas.

8. Composition of claim 7 wherein the inert gas is a noble gas, preferably helium.

## Revendications

1. Procédé anisotrope au plasma gazeux, mis en oeuvre dans un mode d'attaque par ions réactifs faisant appel à un gaz d'attaque pour l'attaque sélective, avec formation d'un motif, d'une couche (24) comprenant du silicium, du polysilicium ou un siliciure de métal réfractaire recouvrant une couche (22) comprenant un oxyde ou un nitrure ou un oxynitrure de silicium, caractérisé en ce que l'agent d'attaque comprend du $CClF_3$ ou du $CCl_2F_2$ capable de fournir des ions CFx et des ions chlore mélangés à 20 à 65 % en volume d'ammoniac, a une pression de 79,8 à 133 $\mu$bar.

2. Procédé selon la revendication 1, caractérisé en ce que la vitesse d'écoulement de la masse est comprise dans la plage de 15 à 100 $cm^3$ étalons/minute (sccm), et de préférence dans la plage de 30 à 60 $cm^3$ étalons/minute (sccm).

3. Procédé selon la revendication 1, caractérisé en ce que lesdites couches (22, 24) forment une surface d'un dispositif à semi-conducteurs.

4. Procédé selon la revendication 1, caractérisé en ce que la couche recouvrante (24) est formée de $N^+$-polysilicium ou de siliciure de tungstène.

5. Procédé selon la revendication 1, caractérisé en ce que la densité de puissance est comprise dans la plage de 0,125 à 0,3 $W/cm^2$.

6. Composition d'attaque pour attaque par ions réactifs, comprenant du $CClF_3$ ou du $CCl_2F_2$ capable de fournir des ions CFx et des ions chlore mélangés à 20 à 65 % en volume d'ammoniac, pouvant augmenter le rapport de vitesse d'attaque d'une couche recouvrante (24), comprenant du silicium, du polysilicium ou un siliciure de métal réfractaire, par rapport à une couche sous-jacente (22) comprenant un oxyde ou un nitrure ou un oxynitrure de silicium.

7. Composition selon la revendication 6, comprenant en outre un gaz inerte.

8. Composition selon la revendication 7, caractérisée en ce que le gaz inerte est un gaz rare, de préférence l'hélium.

## Patentansprüche

1. Anisotropisches Gas-Plasma-Verfahren durchgeführt als reaktives Ionenätzen unter Verwendung eines Ätzgases zum selektiven Musterätzen einer Schicht (24) aus Silizium, Polysilizium oder hitzebeständigem Metallsilizid über einer Schicht (22) bestehend aus einem Oxyd oder Nitrid oder Oxynitrid von Silizium, wobei das Ätzmittel $CClF_3$ oder $CCl_2F_2$ enthält und CFx und Chlorionen in einer Mischung mit 20 bis 65 Volumprozent Ammoniak bei einem Druck von 79,8 bis 133 $\mu$bar zugeführt werden können.

2. Verfahren nach Anspruch 1, wobei die Mengenflußrate im Bereich von 15 bis 100 standard $cm^3$/min (sccm), vorzugsweise im Bereich von 30 bis 60 standard $cm^3$/min (sccm), liegt.

3. Verfahren nach Anspruch 1, wobei die Schichten (22, 24) eine Oberfläche einer Halbleiteranordnung bilden.

4. Verfahren nach Anspruch 1, wobei die obenliegende Schicht (24) aus N + Polysilizium oder aus Wolframsilizid besteht.

5. Verfahren nach Anspruch 1, wobei die Leistungsdichte im Bereich von 0,125 bis 0,3 $W/cm^2$ liegt.

6. Ätzzusammensetzung für reaktives Ionenätzen enthaltend $CClF_3$ oder $CCl_2F_2$, das die Zufuhr von CFx und Chlor in einer Mischung mit 20 bis 65 Volumprozent Ammoniak erlaubt und eine Erhöhung der Ätzrate der obenliegenden Schicht (24) am Silizium, Polysilizium oder einem hitzebeständigen Metallsilizid gegenüber der Ätzrate der untenliegenden Schicht (22) an einem Oxyd oder Nitrid oder Oxynitrid von Silizium bewirkt.

7. Zusammensetzung nach Anspruch 6 enthaltend zusätzlich ein inertes Gas.

8. Zusammensetzung nach Anspruch 7, bei der das inerte Gas ein Edelgas, vorzugsweise Helium, ist.

Fig. 1a

Fig. 1b

Fig. 1c

Fig. 2

Fig. 3

Fig. 4a

Fig. 4b

Fig. 4c

Fig. 4d

Fig. 5a

Fig. 5b

Fig. 5c

Fig.6a

Fig.6b

Fig.6c

13